# FASCICULE DE BREVET EUROPEEN

(11) **EP 0 880 694 B1**
(45) Date de publication et mention de la délivrance du brevet: **29.01.2003**
(21) Numéro de dépôt: 96941722.9
(22) Date de dépôt: 09.12.1996
(51) Int. Cl.: G01N 29/04, G01N 29/20

(54) **PROCEDE DE CONTROLE PAR ULTRASONS DES CIBLES DE PULVERISATION CATHODIQUE**
VERFAHREN ZUM ULTRASCHALLTESTEN VON ZIELELEMENTEN FÜR KATHODENZERSTÄUBUNG
ULTRASONIC SPUTTERING TARGET TESTING METHOD

(30) Priorité: 13.02.1996 FR 9601990
(43) Date de publication de la demande: 02.12.1998
(73) Titulaire: ALUMINIUM PECHINEY, 92400 Courbevoie (FR)
(72) Inventeur: LEROY, Michel, F-38120 Saint-Egrève (FR); MULLER, Jean, F-09400 Tarascon-sur-Ariège (FR)
(74) Mandataire: Mougeot, Jean-Claude
(86) Numéro de dépôt international: FR9601959
(87) Numéro de publication internationale: WO97030348

(56) Documents cités:
- US-A- 4 366 713
- US-A- 4 741 212
- US-A- 5 406 850
- PATENT ABSTRACTS OF JAPAN vol. 012, no. 443 (P-790), 22 Novembre 1988 & JP 63 172960 A (MEIDENSHA ELECTRIC MFG CO LTD), 16 Juillet 1988,

## Description

### DOMAINE TECHNIQUE

L'invention concerne des procédés de contrôle, notamment par ultrasons, de la santé interne des cibles ou cathodes à base d'aluminium de très haute pureté destinées à la pulvérisation cathodique sur un substrat pour la fabrication notamment de circuits intégrés, ainsi que des précurseurs de ces cibles ou cathodes. Dans la suite le mot "cible" désigne aussi les cathodes.

### ETAT DE LA TECHNIQUE ET PROBLEME POSE

La pulvérisation cathodique est une technique de dépôt dont le principe est abondamment décrit dans la littérature scientifique spécialisée. Elle permet de déposer pratiquement tous les types de matériaux, réfractaires ou non, alliés ou non, conducteurs ou diélectriques, sur tous les types de substrat qui acceptent une mise sous vide et un léger échauffement. Cette technique de dépôt a trouvé une application particulièrement importante en électronique pour le revêtement par un alliage d'aluminium de plaquettes de silicium semi-conducteur et la fabrication des circuits intégrés. Ainsi la fabrication des circuits intégrés à très haut niveau d'intégration, par exemple des mémoires dynamiques DRAM de capacité supérieure à 4 Mégabits, nécessite le dépôt de couches métalliques d'interconnexion de faible épaisseur (environ 1µm), qui sont ensuite gravées pour former des lignes extrêmement fines (moins de 0,5 µm de largeur) permettant l'accès individuel à chaque position mémoire.

On conçoit que dans ces conditions, tout défaut de la couche de métallisation, de taille proche de la largeur d'une ligne d'interconnexion puisse conduire à un défaut rédhibitoire lors de l'opération de gravure du circuit d'interconnexion, et entraîner le rebut du circuit intégré.

Parmi ces défauts des couches de métallisation, obtenues par pulvérisation cathodique sous vide à partir d'une cible métallique, l'un des plus fréquents est l'arrachage de fines particules de la surface de la cible et la redéposition de ces fines particules solides ou liquides ou poussières sur le substrat semi-conducteur en cours de métallisation. Ces poussières, ou particules, ont généralement une taille comprise entre quelques dixièmes de microns et quelques microns.

Pour les générations antérieures de circuits intégrés, dont la largeur de gravure était de plusieurs microns, la majorité des particules ainsi redéposées sur la couche métallisée du substrat ne provoquait pas de défaut de gravure significatif, et la proportion de substrats métallisés rebutés pour défaut de gravure due à cette cause était supportable.

Par contre, pour les générations actuelles et futures de circuits ultra-intégrés, par exemple les mémoires DRAM de 16 Mégabits et au-delà, la finesse de gravure a été très sensiblement accentuée, et la largeur de ligne a été ramenée à quelques dixièmes de microns (actuellement, de l'ordre de 0,2 à 0,5 µm). Dans ces conditions, les particules très fines arrachées à la cible, et redéposées sur le substrat semi-conducteur, sont devenues une cause majeure de rebut des circuits intégrés, et ce défaut coûte chaque année des sommes d'argent considérables à l'industrie électronique mondiale, supérieures de plusieurs ordres de grandeur au coût des cibles de métallisation utilisées.

Il devient évident que la suppression de ce défaut, ou tout au moins sa limitation, est un enjeu majeur pour l'industrie de l'électronique, et justifie les efforts très importants de recherche et développement de cette industrie pour comprendre l'origine de ce défaut et y remédier.

Ces efforts toutefois sont restés jusqu'à présent sans effet, en dépit des tentatives visant à agir sur les conditions d'élaboration de la cible, par exemple par affinement et homogénéisation des tailles de grains en-dessous de 0,1 mm selon EP-A-0466617 (US 5160388). A noter encore que dans ce domaine les méthodes de contrôle non destructif, notamment les méthodes de contrôle par ultrasons, de la régularité de la couche métallique active de la cible relativement à une couche de référence ayant une taille moyenne des grains équivalente, selon US 5406850, ne sont d'aucun secours pour expliquer, et a fortiori limiter, ce grave inconvénient.

Diverses hypothèses ont été émises quant à l'origine des particules redéposées sur le substrat en cours de métallisation :
. Une première hypothèse est un mécanisme en deux étapes :
   - Dans une première étape, une partie du métal arraché atome par atome à la cible se dépose sur les parois du réacteur de pulvérisation, ou sur des équipements contenus dans ce réacteur, tels que la grille de collimation située entre la cible de pulvérisation et le substrat, et y forme un fin dépôt.
   - Dans une deuxième étape, ce dépôt est réarraché à son support, sous forme de fines particules, et est projeté sur le substrat semi-conducteur en cours de métallisation.
   Cependant ce mécanisme, s'il existe, ne peut être que tout à fait secondaire, car il n'explique pas une observation majeure qui est la suivante :
   Lorsqu'on observe un fort taux d'émission et de redéposition de particules, sur plusieurs substrats consécutifs, il suffit très souvent de changer la cible de pulvérisation pour que le phénomène s'arrête : l'émission (et la redéposition) de particules est donc une caractéristique intrinsèque de la cible.
. Une deuxième hypothèse émise, pour expliquer cet effet caractéristique, lié à une propriété inconnue de la cible de pulvérisation, a été de soupçonner la présence dans le métal d'inclusions fines, telles que des inclusions d'oxydes, de nitrures, de carbures, etc... dans la matrice métallique composant la cible.

Ces particules réfractaires et non conductrices électriques, pourraient se charger électriquement sous l'effet du bombardement de la cible par les ions d'argon, puis finalement donner lieu à l'accrochage d'un arc électrique (phénomène appelé « arcing »), puis à la fusion du métal entourant la particule et à sa projection sous forme de multiples gouttelettes liquides microniques sur le substrat (phénomène appelé « splashing » ou « éclaboussure »), ou encore à l'explosion de la particule réfractaire sous l'effet de la charge électrostatique accumulée (phénomène dit d'empoussièrement, ou « dusting »).

Cette hypothèse, qui fait appel à la présence d'inclusions en teneur variable de cible à cible, explique bien certains des phénomènes observés expérimentalement, et en particulier les phénomènes d'amorçage local d'arc électrique sur la cible, en cours d'utilisation, que l'on observe parfois.

Ainsi dans une publication « Effect of thin film oxide inclusions on aluminium target arcing and particulate » présentée à Minneapolis en Octobre 1995 au congrès annuel de la Société Américaine du Vide, A.Leybovich, R.S.Barley et J.Poole de TOSOH SMD Inc. indiquent que de larges particules d'oxyde d'aluminium (⌀ > 1mm) provenant d'une oxydation électrochimique locale de la surface de la cible et réparties parallèlement à cette surface peuvent provoquer de « l'arcing ». Toutefois des défauts aussi étendus sont détectables par les contrôles ultrasons classiques entre 1 MHz et 3 MHz et ne sont normalement pas présents dans les cibles industrielles après contrôle normalisé prévoyant l'élimination des cibles pour un seuil de défaut à 0,7 mm.

Ce phénomène n'est donc pas général : il s'agit d'un phénomène « catastrophique » et destructeur, heureusement peu courant, et ne saurait expliquer qu'une fraction souvent limitée des émissions de particules submicroniques observées de façon plus courante, sauf si le métal ayant servi à fabriquer la cible était particulièrement sale, et comportait en particulier des quantités importantes d'inclusions réfractaires de taille importante, présentes initialement dans le métal liquide ou générées pendant le processus de coulée, par exemple plus de 5 milligrammes de particules réfractaires de taille moyenne supérieure à 30 µm, par kilogramme de métal.

En outre, cette hypothèse n'explique pas une autre observation expérimentale, connue des spécialistes de la métallisation des circuits intégrés, qui est que le taux d'émission de particules est fonction de l'alliage constituant la cible, les alliages Aluminium-Silicium-Cuivre (par exemple Al+1% Si+0,5% Cu) étant les plus sensibles, suivis des alliages Aluminium-Silicium (par exemple Al+1% Si), et enfin les alliages Aluminium-Cuivre peu chargés en Cuivre (par exemple Al+0,5% Cu) étant les moins sensibles.

Or, on n'a jamais mis en évidence de corrélation entre la composition chimique de l'alliage constituant la cible, et sa teneur en inclusions réfractaires, et cette relation entre nature de l'alliage constituant la cible et taux d'émission de particules est jusqu'à présent restée mystérieuse.

La demanderesse a donc cherché à obtenir des cibles de pulvérisation cathodique pour l'industrie de l'électronique qui présentent de façon sûre des taux très limités d'émission de particules, quel que soit l'alliage à base d'aluminium utilisé, ainsi que des précurseurs de cibles, et produits intermédiaires, qui permettent de les obtenir de manière fiable et satisfaisante.

### OBJET DE L'INVENTION

L'invention a pour objet un procédé de contrôle de cibles en aluminium ou en alliage d'aluminium qui permette d'obtenir les cibles selon l'invention. Le procédé selon l'invention est plus particulièrement appliqué à la partie active des cibles, c'est-à-dire la partie de la cible qui est susceptible d'être enlevée lors de la pulvérisation cathodique et qui est plus spécifiquement en aluminium de très haute pureté ou en alliage d'aluminium à base très pure.

Le procédé de contrôle de cibles de pulvérisation cathodique selon l'invention est caractérisé en ce que, à l'aide d'une méthode de contrôle de la santé interne du métal, non destructive et sensible aux décohésions internes,
- on détermine la taille des décohésions des cibles à contrôler, de préférence par comparaison à des cibles de référence ou à des défauts artificiels de référence, dans un but de calibration,
- on effectue un comptage en taille et en nombre des décohésions internes par unité de volume desdites cibles à contrôler,
- on sélectionne, selon un critère basé sur la répartition en taille et en nombre des décohésions, les cibles qui permettent de réduire à moins de 5% le taux de rebut des substrats métallisés pour cause de redéposition de particules solides ou liquides.

L'invention a aussi pour objet un procédé de contrôle également sensible aux décohésions internes qui permette d'obtenir des précurseurs de cible. Lesdits précurseurs comprennent en particulier les billettes de départ en aluminium de très haute pureté ou en alliage d'aluminium à base très pure, brutes de coulée ou traitées thermiquement, et les produits intermédiaires tels que des tronçons desdites billettes et des ébauches de cibles.

L'invention apporte en effet une solution au problème posé et est fondée sur le constat inattendu qu'il existe une corrélation entre le taux d'émission des particules et le nombre et la taille de défauts dans le métal résiduel de la cible se présentant principalement sous forme de décohésions planes mesurables par une méthode de contrôle sensible à ces décohésions. La présence de décohésions est parfois associée sur la surface de la cible à de petites boursouflures.

### DESCRIPTION DE L'INVENTION

Les cibles de pulvérisation pour la métallisation de circuits intégrés ou de circuits électroniques, dont la partie active est formée d'aluminium de très haute pureté ou d'un alliage d'aluminium à base très pure, sélectionnées selon le procédé selon l'invention, sont caractérisées en ce qu'elles présentent de préférence une densité de décohésion inférieure ou égale à 0,1 décohésion de taille supérieure à 0,1 mm par centimètre cube de métal actif de la cible, et de préférence encore inférieure à 0,01 décohésion par centimètre cube dudit métal.

Le procédé de contrôle de ciblés de pulvérisation cathodique selon l'invention est caractérisé en ce que :
- à l'aide d'une méthode de contrôle de la santé interne du métal non destructive sensible aux décohésions internes, on détermine la taille des décohésions des cibles à contrôler, de préférence par comparaison à des cibles de référence ou à des défauts artificiels de référence, dans un but de calibration,
- on effectue un comptage en taille et en nombre des décohésions internes par unité de volume desdites cibles à contrôler,
- on sélectionne, notamment pour les applications nécessitant une très grande finesse de gravure, les cibles présentant de préférence une densité de décohésions inférieure ou égale à 0,1 décohésion de taille supérieure à 0,1 mm par centimètre cube de métal actif de la cible, et de préférence encore inférieure à 0,01 décohésion par centimètre cube dudit métal.

La méthode de contrôle est choisie parmi les méthodes qui permettent de déterminer la taille des décohésions dans l'aluminium de très haute pureté ou dans les alliages d'aluminium à base très pure, telles que les méthodes ultrasonores, les méthodes à base de courants de Foucault, de préférence focalisés, ou les méthodes à rayons X, de préférence focalisés.

Selon une réalisation préféré de l'invention, le procédé utilise une méthode de contrôle à ultrasons et est caractérisé en ce que :
après avoir choisi un capteur ultrasonore fonctionnant à une fréquence de travail supérieure à 5 MHz, et de préférence entre 10 et 50 MHz, et après un réglage de la chaîne de mesure appropriée indiquant l'amplitude de l'écho ultrasonore d'un défaut artificiel de dimension connue, simulant une décohésion dans une cible immergée dans un liquide, en fonction de la position dudit défaut par rapport à la surface de la cible :
   - on détermine la taille des décohésions des cibles à contrôler, par comparaison à l'amplitude de l'écho ultrason obtenu avec le défaut artificiel dans un volume donné paramétré par le contrôle ultrasonore,
   - on effectue un comptage en taille et en nombre des décohésions internes par unité de volume desdites cibles à contrôler,
   - on sélectionne les cibles présentant une densité de décohésion de préférence inférieure ou égale à 0,1 décohésion de taille supérieure à 0,1 mm par centimètre cube de métal actif de la cible, et de préférence encore inférieure à 0,01 décohésion par centimètre cube dudit métal.

De manière avantageuse, la méthode de contrôle met en oeuvre, avec un capteur ou sonde réglé sur la fréquence de travail, une chaîne de mesure appropriée, c'est-à-dire un émetteur délivrant une impulsion de durée compatible avec la fréquence du capteur et un récepteur dont la sensibilité est maximale dans la bande de fréquence utilisée.

En observant de façon attentive des cibles partiellement usagées ayant donné lieu à des taux élevés d'émission de particules, la demanderesse a constaté curieusement que plusieurs de ces cibles comportaient, sur la surface érodée sous l'effet de l'arc, de minuscules boursouflures (ou soufflures) de taille comprise entre 0,1 mm et parfois jusqu'à 1 mm de diamètre, certaines de ces boursouflures étant d'ailleurs ouvertes avec des bords érodés.

En pratiquant des sections de ces boursouflures, il s'est avéré que l'intérieur de ces boursouflures était vide et que la base en était sensiblement plane et parallèle à la surface initiale de la cible. Cette base comportait parfois quelques inclusions d'oxydes ou des précipités d'éléments d'alliage, mais ceci n'était pas un phénomène généralisé. Il était en effet plus fréquent pour les alliages faiblement chargés en éléments d'addition (par exemple Al + 0,5% Cu) mais beaucoup moins général pour les alliages plus fortement chargés (par exemple Al + 1% Si + 0,5% Cu).

En effectuant un contrôle par ultrasons à haute fréquence, à plus de 5 MHz sur le métal résiduel de ces cibles, la présence dans ce métal de décohésions planes, parallèles à la surface de base de la cible a été détectée. Le diamètre apparent de ces décohésions, tel que jugé par référence au défaut artificiel en l'occurrence un trou à fond plat de 0,1 mm de diamètre, était compris entre environ 0,04 mm et 0,4 mm. L'abondance de ces défauts était variable mais était de plus d'une décohésion de taille supérieure à 0,04 mm par centimètre cube de métal inspecté, et très souvent plus de 0,1 décohésion de diamètre supérieur à 0,1 mm, par centimètre cube de métal inspecté.

Ce constat surprenant d'une corrélation entre le taux d'émissions de particules, la présence dans le métal résiduel de la cible de décohésions planes de dimensions comprises entre 0,04 mm et 0,4 mm, et la présence, à la surface de la cible usagée, de petites boursouflures ou de cratères de diamètre généralement supérieur 0,1 mm, mais parfois simplement supérieur à 0,04 mm, constitue la base de l'invention.

La demanderesse a aussi constaté que le produit brut de coulée dont est issue la cible défectueuse comporte, à l'origine, de petites décohésions telles que microporosités, ou microretassures, ou encore des inclusions réfractaires, de taille équivalente - en ordre de grandeur - à ces défauts sur cibles.

A titre simplement de tentative d'explication, on peut penser que le mécanisme conduisant à l'émission abondante de particules solides ou liquides de taille submicronique ou micronique, par une cible défectueuse en cours d'utilisation pourrait être le suivant.

Lors de la transformation en ébauches de cibles, par forgeage, pressage et/ou laminage, des décohésions de forme quelconque sont écrasées et aplaties parallèlement à la surface de l'ébauche. Ces décohésions, qui constituent un obstacle local à l'évacuation de la chaleur amenée à la cible par l'impact du faisceau ionique destiné à en arracher progressivement les atomes métalliques constituant la partie active de la cible, entraînent un échauffement de plus en plus rapide de la membrane séparant la décohésion plane de la surface de la cible. Cet échauffement de la membrane, d'autant plus important que l'épaisseur de la membrane diminue, peut alors atteindre un point tel que cette membrane atteigne sa température de fusion. La fusion se produirait lorsque l'épaisseur de la membrane résiduelle atteindrait environ 1/1000 à 1/10 ème du diamètre de la décohésion. Plusieurs facteurs, tels que la puissance transmise à la partie active de la cible par l'arc ionique, la conductivité thermique ou électrique de l'alliage utilisé, son état métallurgique, affectent de plus d'un ordre de grandeur la taille critique des décohésions donnant lieu à une fusion de la membrane séparant la décohésion responsable de l'émission de particules, de la surface érodée lors de l'utilisation de la cible, c'est-à-dire que la taille critique des décohésions responsables de la redéposition de particules pourrait être comprise entre 0,01 mm et 1 mm, selon les conditions précises d'exploitation, mais se situe le plus souvent entre 0,04 et 0,4 mm dans les conditions industrielles usuelles.

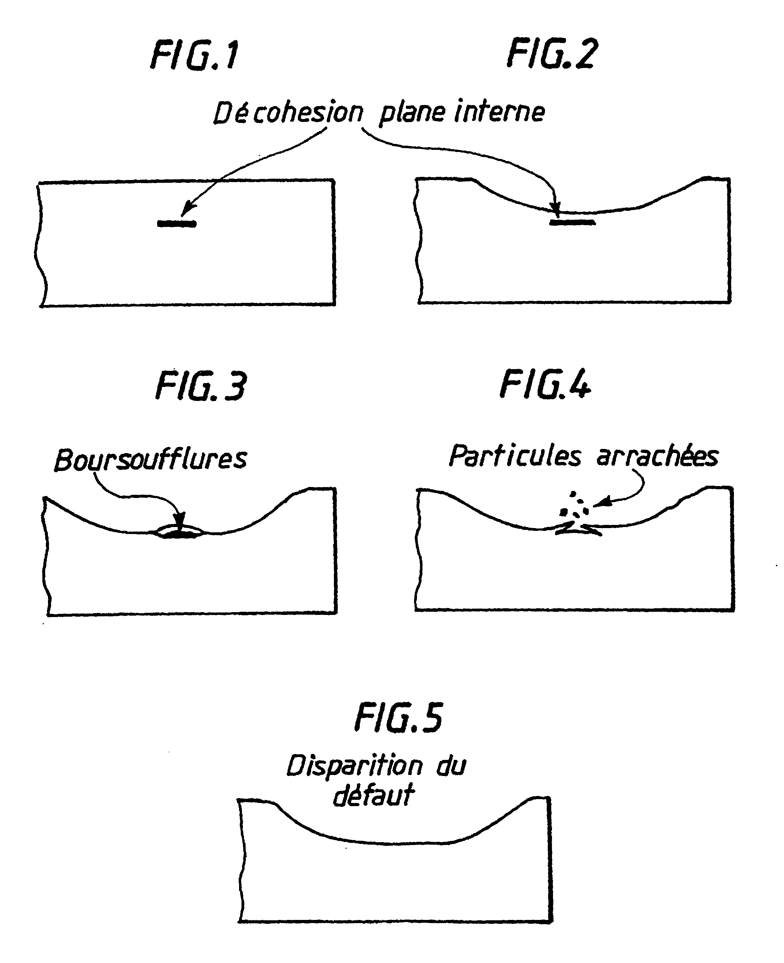

Un phénomène aggravant pourrait également être le suivant, en se référant aux figures 1 à 5 représentatives des phases successives d'endommagement de la cible. Lors des traitements thermiques de transformation, l'hydrogène dissous sous forme atomique dans le métal, et en forte sursaturation, diffuse vers ces décohésions et s'y dégage sous forme d'un gaz moléculaire (dont la pression peut atteindre plusieurs atmosphères).

Au moment de sa mise en place dans l'appareil de pulvérisation cathodique, la cible défectueuse comporte donc des décohésions planes, parallèles à la surface de la cible, et en outre remplies d'hydrogène moléculaire, selon figure 1, ces décohésions pouvant éventuellement comporter de fortes concentrations locales d'inclusions ou de précipités.

Lors de la pulvérisation cathodique, la surface libre de la cible s'érode progressivement jusqu'à ce que la décohésion plane interne à la cible ne soit plus séparée de cette surface que par une fine membrane de métal, selon figure 2.

L'effet aggravant de la présence d'hydrogène moléculaire occlus est que sous l'effet de la différence de pression existant entre l'hydrogène contenu dans la décohésion, et le vide régnant dans la chambre de pulvérisation cathodique, cette fine membrane se soulève pour donner naissance en cours de pulvérisation à une boursouflure, ou protubérance consistant en une fine membrane de métal séparée du métal massif constituant le reste de la cible, selon figure 3.

On peut alors penser que cette membrane, séparée de son support massif et formant une protubérance importante, est arrachée par petits fragments solides ou liquides lors de la suite de la pulvérisation cathodique, et que ces fragments de membrane arrachés à la cible redéposent sur le substrat en cours de métallisation, selon figure 4. Ces fragments de membrane peuvent en outre être associés à des particules solides, telles que des particules intermétalliques ou des inclusions, initialement présentes sur les surfaces limitant la décohésion.

Enfin, la pulvérisation cathodique se poursuivant l'érosion de la surface de la cible fait disparaître progressivement la membrane, selon figure 5, et donc le défaut à l'origine de l'émission de particules.

Plusieurs observations viennent à l'appui de ces propositions de mécanismes :
- D'une part, on constate très souvent que le dépôt de particules sur le substrat semi-conducteur apparaît brutalement, touche plusieurs substrats consécutifs, puis disparaît.
   Ceci pourrait correspondre au temps nécessaire pour que la membrane, épaisse initialement de quelques microns ou quelques dizaines de microns, soit complètement érodée et que le défaut ait donc disparu.
- D'autre part, on constate que les alliages les plus sensibles au phénomène d'émission de particules sont également ceux dont l'intervalle de solidification (c'est-à-dire l'écart entre la température de début de solidification et la température de fin de solidification) est le plus grand : ce sont donc aussi les alliages les plus sensibles à la formation de microporosités, ou de microretassures de retrait de fin de solidification, et ceci toutes autres conditions égales par ailleurs (teneur en gaz dissous, ou en inclusions).

De plus, sur certaines cibles défectueuses ayant donné lieu à un fort taux d'émission de particules, aucune boursouflure de très petite taille, inférieure à 0,1 mm de diamètre, n'a été détectée, alors qu'il existe dans le métal résiduel de la cible de nombreux défauts plans de dimension inférieure à 0,1 mm, et en particulier de nombreux défauts de taille supérieure à 0,04 mm.

Ceci pourrait peut-être s'expliquer de la façon suivante :
Pour qu'une boursouflure puisse se former, sous l'effet de la pression interne de l'hydrogène contenu dans la décohésion plane, il faut que l'épaisseur de la membrane de métal, séparant la décohésion de la surface de la cible en cours d'érosion, tombe en-dessous d'une valeur critique qui est proportionnelle au diamètre de la décohésion et dépend en outre de la pression interne d'hydrogène et de la résistance mécanique de la membrane, fonction de l'alliage et de la température.
Pour des décohésions de très petite taille (moins de 0,1 mm) cette épaisseur critique est très faible (environ de 1 à 10 µm, à titre d'ordre de grandeur).

Dans ces conditions, et en prenant en compte l'échauffement de la surface de la cible sous l'effet du bombardement ionique, l'hydrogène présent dans la décohésion a le temps de diffuser à travers le métal, vers le vide de la chambre de pulvérisation, avant que l'épaisseur critique résiduelle permettant la formation d'une boursouflure ne soit atteinte. Ceci, par ailleurs, ne modifie pas l'effet d'isolant thermique joué par la décohésion, même de petite taille, et peut provoquer la fusion de l'alliage.

La décohésion se vidant ainsi, par diffusion à travers la membrane résiduelle, de l'hydrogène qu'elle contenait, il ne peut plus se former de boursouflure, car la force motrice de sa formation (la pression d'hydrogène interne) disparaît. Cette explication potentielle basée sur l'observation implique en conséquence que seules les décohésions de taille supérieure à une taille critique, de l'ordre de 0.1 mm pour un métal d'une teneur normale et habituelle en hydrogène, c'est-à-dire moins de 0,20 ppm et de préférence moins de 0,10 ppm, peuvent donner lieu à la formation de boursouflures en cours d'opération, et donc favoriser l'émission plus importante de particules qui sont ensuite redéposées sur les substrats semi-conducteurs. Ceci n'empêche pas que de telles décohésions de faible taille, qui forment une barrière thermique à l'évacuation de la chaleur amenée par le faisceau ionique, puissent entraîner la fusion locale, au droit de ces décohésions, de l'alliage formant la partie active de la cible, et donc la projection, sur le substrat à métalliser, de gouttelettes liquides rédhibitoires.

L'homme de l'art comprendra que l'ordre de grandeur de la taille critique des défauts donnant lieu à émission de particules, peut varier en fonction de l'alliage (résistance mécanique de la membrane résiduelle), des conditions de déposition (température de surface de la cible, vitesse d'érosion de la surface par le bombardement ionique) etc... et qu'il ne s'agit donc que d'un ordre de grandeur s'appliquant aux alliages et aux modes de déposition les plus usités actuellement. Dans certains cas, des décohésions de taille comprise entre 0,03 mm et 0,1 mm pourraient également donner lieu à émission de particules solides ou liquides, même en l'absence de teneurs importantes (> 0,2 ppm) d'hydrogène dissous ou occlus.

De manière à éviter la transformation inutile de précurseurs contenant à l'origine des décohésions rédhibitoires, ce qui permet notamment de réduire le taux de rebut lors des contrôles, une variante du procédé selon l'invention comprend un contrôle des précurseurs et/ou des produits intermédiaires permettant de déterminer leur santé interne, c'est-à-dire de déterminer la taille des décohésions qu'ils contiennent, ainsi que le nombre de décohésions par unité de volume.

En particulier, ces contrôles sont avantageusement effectués sur les tranches de billette brute de coulée adjacentes au lopin destiné à la transformation en cible. Ces contrôles sont de préférence effectués sur les faces planes des tranches. Lors de ces contrôles, on sélectionne de préférence les précurseurs et/ou les produits intermédiaires qui ne présentent aucune décohésion de taille supérieure à 0,1 mm et moins de 10 décohésions de taille supérieure à 0,04 mm par tranche.

Les contrôles sur tranches de billettes sont avantageusement effectués après un traitement thermique d'homogénéisation, ce qui permet d'éviter de confondre les décohésions et les phases intermétalliques précipitées lors de la solidification.

Il est également avantageux d'effectuer les contrôles de santé interne sur les produits intermédiaires issus d'une première étape de corroyage des tranches de billette, qui tend à augmenter la taille des décohésions de manière à les rendre rédhibitoires. Le corroyage est en général obtenu par pressage, par forgeage ou par laminage. Ces contrôles intermédiaires permettent d'éviter de continuer inutilement la transformation jusqu'à l'étape finale de fabrication de la cible. Lors de ces contrôles, on sélectionne de préférence les précurseurs et/ou les produits intermédiaires qui ne présentent aucune décohésion de taille supérieure à 0,1 mm et moins de 10 décohésions de taille supérieure à 0,04 mm par pièce.

Les précurseurs de cibles de pulvérisation cathodique, en aluminium de très haute pureté ou en alliage d'aluminium à base très pure, pour la métallisation de circuits intégrés ou de circuits électroniques, contiennent donc de préférence moins de 10 décohésions de taille supérieure à 0,04 mm par 100 cm³.

La mise en oeuvre de l'invention sera mieux comprise à partir des exemples détaillés ci-après.

### EXEMPLES

Le mode de réalisation préféré du procédé selon l'invention est appliqué ici à un alliage d'aluminium à 1% de silicium et 0,5% de cuivre pour cible mais il ne se limite évidemment pas à ce seul alliage d'aluminum.

### Préparation des cibles

Dans 13 coulées différentes d'un même alliage Al+1% Si+0,5% Cu, la demanderesse a prélevé un tronçon de billette brute, de longueur unitaire 600 mm et de diamètre brut 137 mm. La teneur en hydrogène de ces produits coulés était systématiquement inférieure à 0,20 ppm et généralement inférieure à 0,10 ppm telle que mesurée avec un appareil de marque ALSCAN ®, sur métal liquide à la coulée, et confirmée par mesure à l'aide d'un appareil d'extraction du gaz par fusion sous vide, de marque STROEHLEIN ®, sur échantillons de solide prélevés dans des tranches de billettes adjacentes au tronçon prélevé.

Sur ces tranches adjacentes aux lopins de longueur 600 mm, on a également pratiqué un test de mesure de la teneur en inclusions consistant à dissoudre la matrice d'alliage d'aluminium et à recueillir par filtration les inclusions non métalliques insolubles (seuil de filtration ≥ 2 µm) qui après séchage sont pesées puis comptées et mesurées par microscopie à balayage.

Les 13 tronçons de billettes ont été dons un premier temps écroûtés par tournage, pour éliminer la peau de coulée de surface, et leur diamètre a été ramené à 130 mm. Puis ces tronçons de billettes ainsi écroûtés ont été soumis à un contrôle classique par ultrasons à une fréquence de 5 MHz, de façon à ne retenir que les tronçons ne présentant pas d'écho supérieur à celui d'un défaut artificiel représenté par un fond plat de diamètre 0,7 mm, selon la norme française AIR n° 9051, qui est la plus sévère existante, pour ce type de produit brut de coulée. Ceci a conduit au rebut de 1 tronçon.

La sensibilité de ce contrôle réglé à ce niveau de fréquence par choix d'un capteur ultrasonore et d'une chaîne de mesure classique, permet la détection de défauts équivalents entre 0,3 mm et 0,8 mm. On utilisera de préférence la norme AIR 9051 dans sa variante dite de contrôle en hélice qui permet d'inspecter 100% du volume de la billette car le capteur est animé d'un mouvement de translation au droit de la billette qui est elle, animée d'un mouvement de rotation, alors que le contrôle basique suivant la norme inspecte seulement les faces et 3 génératrices de la billette.

Ceci a conduit au rebut de 1 tronçon qui a permis par ailleurs de constater que la teneur en inclusions mesurée sur l'une des tranches adjacentes à ce tronçon dépassait 10 mg d'inclusions de taille supérieure à 2 µm par kg de métal alors que cette teneur restait inférieure à 5 mg d'inclusions de taille supérieure à 2 µm par kg de métal sur toutes les tranches adjacentes aux 12 tronçons ayant satisfait à ce premier contrôle ultrasonore.

Les 12 tronçons ainsi sélectionnés ont ensuite été transformés en ébauches de cibles, selon le mode opératoire décrit dans EP-A-0466617 (US 5160388) attribué à la demanderesse, si ce n'est que le traitement d'homogénéisation a été légèrement adaptée pour cet alliage en particulier.

Cette homogénéisation s'est faite en 2 stades, le premier stade correspondant à un maintien de 8 heures à 510°C, de façon à remettre en solution les constituants de l'eutectique ternaire apparus en fin de solidification, suivi d'un deuxième stade consistant en un maintien supplémentaire de 4 heures à 560°C, pour parfaire l'homogénéité de composition chimique du produit, à l'échelle des grains individuels. Après tronçonnage de chaque billette de 600 mm environ d'épaisseur en 3 morceaux de largeur 160 mm séparés par des tranches de contrôle, la suite des opérations a été parfaitement conforme à l'enseignement du brevet précité, et a conduit à des ébauches de cibles, de diamètre environ 330 mm et d'épaisseur 25 mm, après des corroyages comportant pressage, laminage croisé, et traitement thermique final de recristallisation, à raison de 3 cibles par lopin de longueur 600 mm initiale.

Une face de chaque ébauche a ensuite été usinée et polie de façon à examiner la structure micrographique des produits transformés. Cet examen a révélé que les produits contenaient de fins précipités de Silicium et d'intermétalliques Al₂Cu, dont la taille moyenne était voisine de 5 à 10 microns, et que la taille de grain de ces produits recristallisés était inférieure à 0,1 mm, et en moyenne de l'ordre de 0,07 mm. En outre, la texture de ces cibles, telle que révélée par un examen par Rayons X (figures de pôles 111 et 200), était très sensiblement isotrope, sans orientations préférentielles des grains.

Toutes les ébauches ainsi produites correspondaient donc, pour tous ces critères (taille des précipités, taille de grain, texture d'orientation des grains) à tous les critères attendus pour une utilisation satisfaisante des cibles pour la métallisation de circuits intégrés.

Ces ébauches ont donc subi un usinage final, par tournage, de façon à obtenir des disques de diamètre 300 mm et d'épaisseur 20 mm, d'un poids unitaire de 3,8 kg environ, et d'un volume proche de 1.400 cm³. Le contrôle ultrasonore effectué manuellement par déplacement du capteur parallèlement à la surface de la cible avec un contact capteur/cible réalisé par une graisse minérale à la fréquence de 5 MHz, a permis d'éliminer les disques présentant des défauts équivalents au défaut artificiel constitué par un trou à fond plat de 0,7 mm, selon la norme française AIR n° 9051. Cette norme utilisée de préférence pour les produits bruts de fonderie peut être avantageusement remplacée par des normes plus fréquemment utilisées pour les produits transformés telles que : AECMA-Pr EN 2003-8 et Pr EN 2004-2, ou encore MIL STD 2154 et Pr EN 4050-4. On a ainsi rebuté 6 ébauches sur 36 à ce contrôle.

### Sélection après contrôle par ultrasons a haute fréquence

Avant de raccorder les disques restants, par soudage, à leur plaque support en cuivre, ceux-ci ont subi un contrôle supplémentaire par ultrasons à haute fréquence.

Ce contrôle supplémentaire consistait à immerger chaque disque usiné dans un bac rempli d'eau. Puis l'on a fait se déplacer, parallèlement à la surface du disque, et selon un balayage X-Y, un capteur ou une sonde à ultrasons fonctionnant sur la fréquence de 15 MHz. Ce capteur a été préalablement calibré par référence à des défauts artificiels constitués par des trous à fond plat de diamètre 0,1 mm, situés à des profondeurs de 6 mm, 12 mm et 18 mm sous la surface d'un alliage identique ayant des caractéristiques métallurgiques similaires à celles du produit à contrôler. Il faut noter à ce sujet que cette plaque étalon ayant elle-même une taille de grain moyenne de 0,07 mm, une orientation des grains isotrope, et des précipités intermétalliques de taille réduite (en moyenne moins de 10 µm), permet tout aussi bien un étalonnage des tailles de défauts sur d'autres alliages d'aluminium peu chargés ayant des caractéristiques morphologiques identiques.

Ceci a permis de tracer la courbe d'étalonnage donnant la mesure de l'amplitude de l'écho correspondant à un trou équivalent à fond plat.

On a alors compté, pour chaque disque, le nombre d'échos dépassant le niveau de bruit et l'amplitude du signal associé, dans le volume actif maximum, ainsi que le nombre d'échos dépassant l'amplitude correspondant au défaut artificiel de 0,1 mm, c'est-à-dire un volume d'environ 1000 cm³ correspondant à une surface active de diamètre 280 mm, sur une profondeur de 18 mm sous la surface.

Les disques ainsi contrôlés ont été classés en 5 catégories :
- Cat. 1: Disques présentant plus de 1000 échos > 0,1 mm par disque (plus de 1 écho/cm³)
- Cat. 2: Disques présentant 100 à 1000 échos > 0,1 mm par disque (de 0,1 à 1 écho/cm³).
- Cat. 3: Disques présentant de 10 à 100 échos > 0,1 mm par disque (de 0,01 à 0,1 écho/cm³).
- Cat. 4: Disques présentant moins de 10 échos > 0,1 mm par disque (moins de 0,01 écho/cm³).
- Cat. 5: Disques ne présentant que des indications comprises entre 0,03 et 0,1 mm dont aucune n'est supérieure à 0,1 mm par disque.

Les disques de ces 5 catégories, tous conformes aux critères de sélection existants pour les cibles de pulvérisation, concernant la taille des grains, la texture d'orientation, la taille des précipités et l'absence de défauts de taille supérieure à 0,7 mm, ont alors été raccordés par soudure à leurs supports de cuivre.

On a alors obtenu :
. 3 cibles de la catégorie 1 (plus de 1 écho/cm³ de métal actif)
. 10 cibles de la catégorie 2 (0,1 à 1 écho/cm³ de métal actif)
. 12 cibles de la catégorie 3 (0,01 à 0,1 écho/cm³ de métal actif)
. 5 cibles des catégories 4 ou 5 (moins de 0,01 écho/cm³ de métal actif).

Ces cibles ont été ensuite utilisées chez un fabricant de circuits intégrés, pour la métallisation de substrats de 8 pouces de diamètre; pour fabrication de mémoires DRAM de 16 Mégabits.

### Résultats des tests comparatifs de métallisation

- Sur les 3 cibles de la catégorie 1, 2 ont dû être arrêtées très rapidement, avec l'apparition extrêmement fréquente de micro-arcs et le dépôt abondant de particules sur les substrats, entraînant 100% de rebut de ces substrats. La troisième cible a été utilisée jusqu'à sa fin de vie normale, mais avec des résultats médiocres : plus de 20% des substrats métallisés avec cette cible ont dû être rebutés, pour présence trop abondante de particules de taille supérieure à 0,5 microns.
- Sur les 10 cibles de la catégorie 2, 2 ont dû être arrêtées avant leur fin de vie normale, pour apparition très fréquente de micro-arcs, et dépôts abondants de particules sur les substrats. Les 8 autres ont donné des résultats médiocres, en moyenne plus de 10% de substrats rebutés après métallisation.
- En ce qui concerne les 12 cibles de catégorie 3, aucune n'a dû être arrêtée en cours d'utilisation, et, en moyenne, moins de 5% des substrats métallisés ont dû être rebutés pour présence abondante de particules.
- Enfin, en ce qui concerne les 5 cibles des catégories 4 ou 5, aucune n'a donné lieu à problèmes, et la proportion de substrats métallisés qui ont dû être rebutés pour présence abondante de particules a été en moyenne inférieure à 2%.

On a pu noter par ailleurs que les mesures de teneur en inclusions pratiquées sur des tranches adjacentes aux lopins dont étaient issues les cibles de catégorie 3, 4 et 5, montraient une teneur pondérale inférieure à 5 milligrammes d'inclusions par kilogramme de métal pour toutes ces cibles. En revanche, plusieurs des cibles, des catégories 1 et 2 précédentes, obtenues également à partir de tels lopins, et présentant donc des teneurs similaires en inclusions, apportaient la confirmation qu'une faible teneur en inclusion était sans doute une condition nécessaire mais en aucun cas suffisante pour obtenir un faible taux de redéposition des particules.

Avant les mesures destructrices de teneur en hydrogène et en inclusions, on a effectué, sur les tranches de billette adjacentes aux tronçons transformés en cibles, des contrôles ultrasonores à haute fréquence, avec faisceau focalisé, dans des conditions similaires aux contrôles effectués sur les ciblés. Ces contrôles ont montré que les cibles ayant donné de nombreux défauts lors de la pulvérisation cathodique provenaient de tronçons de billette dont au moins une tranche adjacente contenait déjà plusieurs décohésions de taille supérieure à 0,1 mm, alors que les cibles ayant donné le moins de défauts provenaient de lopins dont les tranches adjacentes contenaient peu de décohésions de taille supérieure à 0,04 mm, c'est-à-dire moins de 10 décohésions par tranche.

Des cibles ont été réalisées dons des conditions comparables à celles décrites ci-haut, mais en partant exclusivement de lopins dont les tranches adjacentes présentaient moins de 6 décohésions de taille supérieure à 0,04 mm par tranche. Le volume inspecté étant de 60 cm³, avec un diamètre de 125 mm et une épaisseur inspectée de 5 mm, le nombre décohésions de taille supérieure à 0,04 mm est inférieur 10 par 100 cm³. On a également caractérisé les produits obtenus après homogénéisation et réduction d'épaisseur à une valeur égale au double de l'épaisseur de la cible finale, ce qui a montré que moins de 5 % de ces produits intermédiaires présentaient un nombre de décohésions de grande taille, c'est-à-dire supérieure à 0,1 mm, supérieur à un par 100 cm³. Les cibles finales obtenues après réduction de l'épaisseur à la valeur finale et après usinage étaient à plus de 90 % exemptes de décohésions de taille supérieure à 0,1 mm et contenaient moins de 30 décohésions de taille supérieure à 0,04 mm par 100 cm³. Les résultats obtenus lors des dépôts par pulvérisation cathodique avec les cibles exemptes de décohésions de taille supérieure à 0,1 mm et contenant moins de 10 décohésions de taille supérieure à 0,04 mm par 100 cm³ ont été excellents. Ceux obtenus avec des cibles exemptes de décohésions de taille supérieure à 0,1 mm, mais contenant plus de 10 décohésions de taille supérieure à 0,04 mm par 100 cm³ ont été sensiblement moins satisfaisants.

### AUTRES EXEMPLES D'APPLICATION

### A) ALLIAGE D'ALUMINIUM A 1% DE SILICIUM

Sur des lots existants de cibles de pulvérisation cathodique provenant de différentes coulées et réalisées en un même alliage d'aluminium de très haute pureté, supérieure à 99,999%, comportant des additions de 1% en poids de silicium, on a pratiqué un contrôle par ultrasons à haute fréquence (15 Mégahertz), en immersion et on a sélectionné :
. d'une part un premier lot de 5 cibles comportant moins de 0,1 décohésion de taille équivalente supérieure à 0,1 mm, par centimètre cube de métal, et aucun défaut supérieur à 0,7 mm
. d'autre part un deuxième lot de 5 cibles comportant plus de 2 décohésions de taille équivalente supérieure à 0,1 mm, par centimètre cube de métal, sans qu'aucun de ces défauts ne dépasse une taille équivalente supérieure à 0,7 mm.

Les cibles ainsi sélectionnées en fonction de leur densité de défauts de taille comprise entre 0,1 mm et 0,7 mm, ont été utilisées à titre expérimental, en alternance, dans une même machine de pulvérisation cathodique, pour métalliser une série de substrats semi-conducteurs de diamètre 6 pouces (environ 150 mm), avec une épaisseur d'aluminium déposée de 1µm. Chaque cible a donc été utilisée pour métalliser plusieurs dizaines de substrats consécutifs.

On a ensuite trié ces substrats sur la base des critères utilisés pour la gravure de circuits intégrés de type Mémoire DRAM 16 Mégabits, avec une finesse de gravure de 0,35 µm.

On a alors constaté que plus de 95% des substrats métallisés à partir de cibles comportant une très faible densité de décohésions supérieure à 0,1 mm, étaient jugés convenables pour cette application selon ces critères concernant la présence ou l'absence de particules déposées.

Par contre, plus de 20% des substrats métallisés à partir de cibles comportant une forte densité de décohésions supérieure à 0,1 mm, mais inférieure à 0,7 mm, ont été jugées inacceptables pour cette application, selon ces mêmes critères.

### B) ALLIAGES D'ALUMINIUM A 0,5% DE CUIVRE

Après utilisation dans un appareil de métallisation de substrats semi-conducteurs à très grande densité d'intégration, on a sélectionné des cibles, partiellement usagées (profondeur d'érosion de l'ordre de 5 mm) en alliage binaire Al + 0,5 % Cu, ayant donné des taux élevés de redéposition de particules solides ou liquides sur les substrats ainsi métallisés, ces taux élevés de redéposition ayant conduit au rebut de plus de 10 % de ces substrats.

Ces cibles partiellement usagées ont, dans un premier temps, été séparées de leurs plaques-supports en cuivre, puis réusinées par un outil diamant, à sec (sans lubrifiant d'usinage), de façon à éliminer leur partie superficielle éventuellement oxydée ou polluée.

Ces cibles ainsi réusinées ont été ensuite soumises à un examen par ultrasons, d'abord dans une bande de fréquence large 10 à 25 MHz centrée ensuite sur 15 MHz et permettant de détecter et compter les défauts de diamètre supérieur ou égal à 0,4 fois celui d'un trou à fond plat étalon de diamètre 0,1 mm.

On a alors constaté que toutes ces cibles ainsi réusinées, issues de cibles défectueuses, contenaient une densité de défauts supérieure à 1 défaut de taille équivalente supérieure à 0,04 mm, par centimètre cube de métal inspecté.

Par contre, pour cet alliage à faible intervalle de solidification, et de façon curieuse, il n'y avait que 2 cibles sur 4 qui contenaient plus de 0,05 défaut de taille équivalente supérieure à 0,1 mm par centimètre cube de métal inspecté.

Chaque cible ainsi inspectée a alors été resciée diamétralement, de façon à obtenir 2 demi-cibles semi-circulaires.
- Un demi-disque par cible a été ensuite soumis à un test de dissolution, visant à dissoudre la matrice d'alliage d'aluminium, et à quantifier la teneur initiale de la cible initiale, en inclusions réfractaires non solubles.
   On a alors constaté que toutes les cibles défectueuses soumises à ce test contenaient plus de 5 milligrammes d'inclusions réfractaires, par kilogramme d'alliage.
- L'autre demi-disque issu de chaque cible, a été usiné de façon à en extraire un échantillon cylindrique solide, pour mesure de la teneur de ces échantillons en hydrogène dissous ou occlus, à l'aide d'un appareil STROEHLEIN^{(R)}. On a alors constaté que la teneur en hydrogène du métal issu des cibles défectueuses était supérieure à 0,12 ppm.

A titre de comparaison, on a prélevé, après test de pulvérisation de durée limitée (environ 25% de leur durée de vie normale) 4 cibles de métallisation ayant donné, au cours de ce test de durée significative mais limitée, un très bas taux de rebut pour cause de redéposition de particules solides ou liquides (moins de 1% de rebut).

Ces cibles partiellement utilisées ont été soumises aux mêmes examens que ceux correspondant aux cibles défectueuses. On a alors constaté que ces cibles d'excellente qualité présentaient systématiquement des teneurs en inclusions réfractaires inférieures à 4 mg par kg de métal et des teneurs en hydrogène dissous ou occlus inférieures à 0,07 ppm. Aucune de ces cibles ne présentait de décohésion interne de taille supérieure à 0,1 mm, et comportaient moins de 0,05 décohésions de taille supérieure à 0,04 mm par centimètre cube de métal ainsi examiné; ce qui était très sensiblement inférieur à ce qui avait été constaté sur les cibles « défectueuses ».

### C) Aluminium non allié de pureté 4N à 6N

A titre d'exemple non limitatif, sur des lots existants de cibles de pulvérisation cathodique provenant du laminage à partir d'une ébauche brute de coulée de section rectangulaire d'aluminium de pureté supérieure à 99,998%, on a sélectionné après contrôle ultrasonore à 15 MHz :
- d'une part un premier lot de 5 cibles rectangulaires comportant moins de 0,01 décohésion de taille équivalente supérieure à 0,1 mm par centimètre cube de métal, et aucun défaut défaut supérieur à 0,7 mm
- d'autre part un deuxième lot de 5 cibles comportant plus de 0,5 décohésions de taille équivalente supérieure à 0,1 mm, par centimètre cube de métal, sons qu'aucun de ces défauts ne dépasse une taille équivalente supérieure à 0,7 mm.
Les cibles ainsi sélectionnées en fonction de leur densité de défauts de taille comprise entre 0,1 mm et 0,7 mm, ont été utilisées à titre expérimental, en alternance dans une machine de pulvérisation cathodique, pour métalliser une série de 500 substrats rectangulaires, destinés à la confection d'écrans à cristaux liquides de dimensions environ 21x28 cm (écrans dits de « 14 pouces»), avec une épaisseur d'aluminium déposée de 1 µm et une largeur de gravure de 10 µm (donc très supérieure à celle des circuits ultra-intégrés). Chaque cible a été utilisée pour métalliser 50 substrats consécutifs.
On a ensuite trié ces substrats en fonction des critères habituellement mis en oeuvre pour la gravure de ces écrans d'assez grandes dimensions, où tout défaut de gravure local conduit au rebut de l'ensemble du substrat métallisé.
On a alors constaté que plus de 95% des substrats métallisés à partir de cibles comportant une très faible densité de décohésions supérieure à 0,1 mm étaient jugés convenables pour cette application selon ces critères concernant la présence ou l'absence de particules déposées.
Par contre, plus de 15% des substrats métallisés à partir de cibles comportant une forte densité de décohésions supérieure à 0,1 mm, mais inférieure à 0,7 mm, ont été jugés inacceptables pour cette application, selon ces mêmes critères.

### INTERET DE L'INVENTION

Ces divers exemples d'application démontrent le très grand intérêt économique de l'invention puisqu'à partir de cibles de pulvérisation cathodique, pour la métallisation de circuits intégrés ou de circuits électroniques, sélectionnées de façon appropriée par une méthode non destructive desdites cibles, il est possible de réduire le taux de rebut des substrats métallisés pour cause de redéposition de particules solides ou liquides à moins de 5%.

## Revendications

1. Procédé de contrôle de cibles de pulvérisation cathodique pour la métallisation de circuits intégrés ou de circuits électroniques, dont la partie active est formée d'aluminium de très haute pureté ou d'un alliage d'aluminium à base très pure, **caractérisé en ce que**, à l'aidé d'une méthode de contrôle de la santé interne du métal, non destructive et sensible aux décohésions internes,
- on détermine la taille des décohésions des cibles à contrôler,
- on effectue un comptage en taille et en nombre des décohésions internes par unité de volume desdites cibles à contrôler,
- on sélectionne, selon un critère basé sur la répartition en taille et en nombre des décohésions, les cibles qui permettent de réduire à moins de 5% le taux de rebut des substrats métallisés pour cause de redéposition de particules solides ou liquides.

2. Procédé selon la revendication 1, **caractérisé en ce qu'**on détermine la taille des décohésions des cibles à contrôler par comparaison à des cibles de référence ou à des défauts artificiels de référence.

3. Procédé selon l'une des revendications 1 et 2, **caractérisé en ce qu'**on sélectionne les cibles présentant une densité de décohésions inférieure ou égale à 0,1 décohésion de taille supérieure à 0,1 mm par centimètre cube de métal actif de la cible.

4. Procédé selon l'une des revendications 1 à 3, **caractérisé en ce que** la méthode non destructive sensible aux décohésions est choisie parmi les méthodes par ultrasons.

5. Procédé selon la revendication 4, **caractérisé en ce que** :
après avoir choisi un capteur ultrasonore fonctionnant à une fréquence de travail supérieure à 5 MHz, et de préférence entre 10 et 50 MHz et après réglage de la chaîne de mesure appropriée indiquant l'amplitude de l'écho ultrasonore d'un défaut artificiel de dimension connue, simulant une décohésion dans une cible immergée dans un liquide, en fonction de la position dudit défaut par rapport à la surface de la cible :
. on détermine la taille des décohésions de chaque cible contrôlée, par comparaison à l'amplitude de l'écho ultrason obtenu avec le défaut artificiel dans un volume donné paramétré par le contrôle ultrasonore,
. on effectue un comptage en taille et en nombre des décohésions internes par unité de volume desdites cibles à contrôler,
. on sélectionne, pour les applications nécessitant une très grande finesse de gravure, les cibles présentant une densité de décohésion inférieure ou égale à 0,1 décohésion de taille supérieure à 0,1 mm par centimètre cube de métal actif de la cible.

6. Procédé selon l'une des revendications 1 à 5, **caractérisé en ce qu'**on sélectionne les cibles présentant une densité de décohésions inférieure à 0,01 décohésion de taille supérieure à 0,1 mm par centimètre cube de métal actif de la cible.

7. Procédé selon la revendication 5, **caractérisé en ce qu'**après avoir choisi une fréquence de fonctionnement du capteur ultrasonore comprise entre 10 et 25 MHz et centrée de préférence sur 15 MHz, on sélectionne les cibles ne présentant aucune décohésion interne de taille supérieure à 0,1 mm et moins de 0,1 décohésion de taille supérieure à 0,04 mm par centimètre cube de métal actif de la cible.

8. Procédé selon la revendication 7, **caractérisé en ce qu'**on sélectionne les cibles ne présentant aucune décohésion interne de taille supérieure à 0,1 mm et présentant moins de 0,05 décohésion de taille supérieure à 0,04 mm par centimètre cube de métal actif de la cible.

9. Procédé selon l'une des revendications 1 et 8, **caractérisé en ce qu'**on sélectionne les cibles dont la teneur en inclusions réfractaires de taille supérieure à 0,1 mm est inférieure à 0,1 inclusion par cm³ de métal actif et dont la teneur globale en inclusions de taille supérieure à 2 µm est inférieure à 5 mg par kg d'alliage.

10. Procédé selon l'une des revendications 1 à 8, **caractérisé en ce qu'**on sélectionne les cibles ne présentant aucune décohésion interne de taille supérieure à 0,1 mm et moins de 0,05 décohésion de taille supérieure à 0,04 mm par centimètre cube de métal actif et dont la teneur globale en inclusions de taille supérieure à 2 µm est inférieure à 4 mg par kg d'alliage.

11. Procédé selon l'une des revendications 1 à 10, **caractérisé en ce qu'**on sélectionne les cibles dont la teneur en hydrogène dissous ou occlus est inférieure à 0,20 ppm et de préférence inférieure à 0,10 ppm.

12. Procédé selon l'une des revendications 1 à 3, **caractérisé en ce que** la méthode sensible aux décohésions est choisie parmi les méthodes par rayons X.

13. Procédé selon l'une des revendications 1 à 3, **caractérisé en ce que** la méthode sensible aux décohésions est choisie parmi les méthodes par courants de Foucault.

14. Procédé selon l'une des revendications 1 et 13, **caractérisé en ce que** les cibles sélectionnées ont été obtenues à partir de précurseurs sélectionnés par un procédé approprié utilisant une méthode de contrôle de la santé interne du métal non destructive sensible aux décohésions internes.

15. Procédé selon la revendication 14, **caractérisé en ce que** les précurseurs contiennent moins de 10 décohésions de taille supérieure à 0,04 mm par 100 cm³.

16. Procédé selon l'une des revendications 1 et 13, **caractérisé en ce que** les cibles sélectionnées ont été obtenues à partir de produits intermédiaires sélectionnés par un procédé approprié utilisant une méthode de contrôle de la santé interne du métal non destructive sensible aux décohésions internes.

## Claims

1. Process for testing cathode sputtering targets for the metallization of integrated circuits or electronic circuits, of which the active part is formed of very high purity aluminium or a very pure aluminium based alloy, **characterised in that** by using a method of testing the internal soundness of the metal that is not destructive and that is sensitive to the internal decohesions :
- one determines the size of the decohesions of the targets to be tested,
- one performs a count in terms of size and number of the internal decohesions per unit volume of the said targets to be tested,
- one selects, according to a criterion based on the distribution of the decohesions in terms of size and number, the targets which allow one to reduce the rate of rejection of the metallized substrates, because of redeposition of solid and liquid particles, to less than 5%.

2. Process according to claim 1, **characterised in that** one determines the size of the decohesions of the targets to be tested by comparison with reference targets or artificial reference defects.

3. Process according to either of claims 1 and 2, **characterised in that** one selects the targets with a decohesion density less than or equal to 0.1 decohesion larger than 0.1 mm per cubic centimetre of active metal of the target.

4. Process according to anyone of claims 1 to 3, **characterised in that** the non-destructive method sensitive to the decohesions is chosen from among the methods using ultrasound.

5. Process according to claim 4, **characterised in that**:
- after choosing an ultrasound sensor operating at a working frequency greater than 5 MHz, and preferably between 10 and 50 MHz, and after adjusting the appropriate measurement system indicating the amplitude of the ultrasonic echo of an artificial defect with a known size, simulating a decohesion in a target immersed in a liquid, as a function of the position of the said defect with respect to the surface of the target:
• one determines the size of the decohesions of each tested target by comparison with the amplitude of the ultrasonic echo obtained with the artificial defect in a given volume, parameterised by the ultrasound test,
• one performs a count in terms of size and number of the internal decohesions per unit volume of the said targets to be tested,
• one selects, for applications requiring very high degree of etching fineness, the targets with a decohesion density less than or equal to 0.1 decohesion larger than 0.1 mm per cubic centimetre of active metal of the target.

6. Process according to anyone of claims 1 to 5, **characterised in that** one selects the targets with a decohesion density less than 0.01 decohesion larger than 0.1 mm per cubic centimetre of active metal of the target.

7. Process according to claim 5, **characterised in that** after choosing an operating frequency of the ultrasound sensor between 10 and 25 MHz and preferably centred on 15 MHz, one selects the targets with no internal decohesion larger than 0.1 mm and less than 0.1 decohesion larger than 0.04 mm per cubic centimetre of active metal of the target.

8. Process according to claim 7, **characterised in that** one selects the targets with no internal decohesion larger than 0.1 mm and less than 0.05 decohesion larger than 0.04 mm per cubic centimetre of active metal of the target.

9. Process according to anyone of claims 1 and 8, **characterised in that** one selects the targets whose content of refractory inclusions greater than 0.1 mm is less than 0.1 inclusion per cm³ of active metal, and whose global content of inclusions larger than 2 µm is less than 5 mg per kg of alloy.

10. Process according to anyone of claims 1 to 8, **characterised in that** one selects the targets with no internal decohesion larger than 0.1 mm and less than 0.05 decohesion larger than 0.04 mm per cubic centimetre of active metal, and whose global content of inclusions larger than 2 µm is less than 4 mg per kg of alloy.

11. Process according to anyone of claims 1 to 10, **characterised in that** one selects the targets with a dissolved or occluded hydrogen content of less than 0.20 ppm and preferably less than 0.10 ppm.

12. Process according to anyone of claims 1 to 3, **characterised in that** the method sensitive to decohesions is chosen among the methods using X-rays.

13. Process according to anyone of claims 1 to 3, **characterised in that** the method sensitive to decohesions is chosen from among the methods using eddy currents.

14. Process according to anyone of claims 1 to 13, **characterised in that** the selected targets have been obtained from precursors selected by an appropriate process using a method of testing the internal soundness of the metal that is non destructive and sensitive to the internal decohesions.

15. Process according to claim 14, **characterised in that** the precursors contain less than 10 decohesions larger than 0.04 mm per 100 cm³.

16. Process according to anyone of claims 1 and 13, **characterised in that** the selected targets have been obtained from intermediate products selected by an appropriate process using a method of testing the internal soundness of the metal that is non-destructive and sensitive to the internal decohesions.

## Patentansprüche

1. Verfahren zur Prüfung von Targets für Kathodenzerstäubung zum Metallisieren integrierter Schaltungen oder elektronischer Schaltkreise, deren Wirkteil aus hochreinem Aluminium oder einer Aluminiumlegierung mit hochreiner Basis gebildet ist, **dadurch gekennzeichnet, dass** mit Hilfe einer zerstörungsfreien und gegen innere Dekohäsionen empfindlichen Prüfmethode zur Bestimmung der inneren Gesundheit des Metalls
- die Größe der Dekohäsionen der zu prüfenden Targets bestimmt wird,
- eine größen- und zahlenmäßige Erfassung der inneren Dekohäsionen pro Volumeneinheit der zu prüfenden Targets durchgeführt wird,
- nach einem auf der größen- und zahlenmäßigen Verteilung der Dekohäsionen beruhenden Kriterium solche Targets ausgewählt werden, die es ermöglichen, den durch Wiederablagerung fester oder flüssiger Teilchen verursachten Ausschussanteil der metallisierten Substrate auf weniger als 5 % zu reduzieren.

2. Verfahren nach Anspruch 1, **dadurch gekennzeichnet, dass** die Größe der Dekohäsionen der zu prüfenden Targets durch Vergleich mit Referenztargets oder künstlichen Referenzfehlern bestimmt wird.

3. Verfahren nach einem der Ansprüche 1 und 2, **dadurch gekennzeichnet, dass** solche Targets ausgewählt werden, die eine Dekohäsionsdichte von kleiner oder gleich 0,1 Dekohäsionen mit einer Größe von über 0,1 mm pro Kubikzentimeter Aktivmetall des Targets aufweisen.

4. Verfahren nach einem der Ansprüche 1 bis 3, **dadurch gekennzeichnet, dass** die zerstörungsfreie, dekohäsionsempfindliche Methode unter den Ultraschallmethoden gewählt wird.

5. Verfahren nach Anspruch 4, **dadurch gekennzeichnet, dass**: nach erfolgter Wahl eines Ultraschallgebers, der mit einer Arbeitsfrequenz > 5 MHz und vorzugsweise zwischen 10 und 50 MHz arbeitet, und nach Einstellung der geeigneten Messkette, welche die Amplitude des Ultraschallechos eines künstlichen Fehlers bekannter Größe, der eine Dekohäsion in einem in einer Flüssigkeit eingetauchten Target simuliert, in Abhängigkeit von der Lage des Fehlers zur Oberfläche des Targets anzeigt,
- die Größe der Dekohäsionen jedes geprüften Targets durch Vergleich mit der Amplitude des Ultraschallechos bestimmt wird, das mit dem künstlichen Fehler in einem durch die Ultraschallprüfung parametrierten gegebenen Volumen erzeugt wird,
- eine größen- und zahlenmäßige Erfassung der inneren Dekohäsionen pro Volumeneinheit der zu prüfenden Targets durchgeführt wird,
- für Anwendungen, die hochfeines Ätzen erfordern, solche Targets ausgewählt werden, die eine innere Dekohäsionsdichte von kleiner oder gleich 0,1 Dekohäsionen mit einer Größe von über 0,1 mm pro Kubikzentimeter Aktivmetall des Targets aufweisen.

6. Verfahren nach einem der Ansprüche 1 bis 5, **dadurch gekennzeichnet, dass** solche Targets ausgewählt werden, die eine innere Dekohäsionsdichte von kleiner als 0,01 Dekohäsionen mit einer Größe von über 0,1 mm pro Kubikzentimeter Aktivmetall des Targets aufweisen.

7. Verfahren nach Anspruch 5, **dadurch gekennzeichnet, dass** nach erfolgter Wahl einer Betriebsfrequenz des Ultraschallgebers zwischen 10 und 25 MHz und vorzugsweise eingestellt auf 15 MHz solche Targets ausgewählt werden, die keine innere Dekohäsion mit einer Größe von über 0,1 mm und weniger als 0,1 Dekohäsionen mit einer Größe von über 0,04 mm pro Kubikzentimeter Aktivmetall des Targets aufweisen.

8. Verfahren nach Anspruch 7, **dadurch gekennzeichnet, dass** solche Targets ausgewählt werden, die keine innere Dekohäsion mit einer Größe von über 0,1 mm aufweisen und weniger als 0,05 Dekohäsionen mit einer Größe von über 0,04 mm pro Kubikzentimeter Aktivmetall des Targets aufweisen.

9. Verfahren nach einem der Ansprüche 1 bis 8, **dadurch gekennzeichnet, dass** solche Targets ausgewählt werden, deren Anteil an schwerschmelzbaren Einschlüssen mit einer Größe von über 0,1 mm kleiner als 0,1 Einschlüsse pro cm³ Aktivmetall ist und deren Gesamtanteil an Einschlüssen mit einer Größe von über 2 µm kleiner als 5 mg pro kg Legierung ist.

10. Verfahren nach einem der Ansprüche 1 bis 8, **dadurch gekennzeichnet, dass** solche Targets ausgewählt werden, die keine innere Dekohäsion mit einer Größe von über 0,1 mm und weniger als 0,05 Dekohäsionen mit einer Größe von über 0,04 mm pro Kubikzentimeter Aktivmetall aufweisen und deren Gesamtanteil an Einschlüssen mit einer Größe von über 2 µm kleiner als 4 mg pro kg Legierung ist.

11. Verfahren nach einem der Ansprüche 1 bis 10, **dadurch gekennzeichnet, dass** solche Targets ausgewählt werden, deren Gehalt an gelöstem oder eingeschlossenem Wasserstoff kleiner als 0,20 ppm und vorzugsweise kleiner als 0,10 ppm ist.

12. Verfahren nach einem der Ansprüche 1 bis 3, **dadurch gekennzeichnet, dass** die dekohäsionsempfindliche Methode unter den Röntgenstrahlmethoden gewählt wird.

13. Verfahren nach einem der Ansprüche 1 bis 3, **dadurch gekennzeichnet, dass** die dekohäsionsempfindliche Methode unter den Wirbelstrommethoden gewählt wird.

14. Verfahren nach einem der Ansprüche 1 bis 13, **dadurch gekennzeichnet, dass** die ausgewählten Targets aus Vorläufern gewonnen wurden, die durch ein geeignetes Verfahren unter Verwendung einer zerstörungsfreien, gegen innere Dekohäsionen empfindlichen Prüfmethode zur Bestimmung der inneren Gesundheit des Metalls ausgewählt werden.

15. Verfahren nach Anspruch 14, **dadurch gekennzeichnet, dass** die Vorläufer weniger als 10 Dekohäsionen mit einer Größe von über 0,04 mm pro 100 cm³ aufweisen.

16. Verfahren nach einem der Ansprüche 1 bis 13, **dadurch gekennzeichnet, dass** die ausgewählten Targets aus Zwischenprodukten gewonnen wurden, die durch ein geeignetes Verfahren unter Verwendung einer zerstörungsfreien, gegen innere Dekohäsionen empfindlichen Prüfmethode zur Bestimmung der inneren Gesundheit des Metalls ausgewählt werden.
